# EUROPEAN PATENT SPECIFICATION

(11) **EP 3 032 527 B1**
(45) Date of publication and mention of the grant of the patent: **15.05.2019**
(21) Application number: 15197977.0
(22) Date of filing: 04.12.2015
(51) Int. Cl.: G09G 3/3225

(54) **CURRENT SENSING CIRCUIT AND ORGANIC LIGHT EMITTING DIODE DISPLAY INCLUDING THE SAME**
TREIBERSCHALTUNG UND OLED-ANZEIGEVORRICHTUNG DAMIT
CIRCUIT DE DÉTECTION DE COURANT ET DISPOSITIF D'AFFICHAGE À DIODES ÉLECTROLUMINESCENTES ORGANIQUES L'INCLUANT

(30) Priority: 09.12.2014 KR 20140176141
(43) Date of publication of application: 15.06.2016
(73) Proprietor: LG Display Co., Ltd., Seoul 150-721 (KR)
(72) Inventor: KIM, SangYun, Seoul (KR); YANG, JunHyeok, Gyeonggi-do (KR)
(74) Representative: Viering, Jentschura & Partner mbB Patent- und Rechtsanwälte

(56) References cited:
- EP-A1- 2 747 066
- US-A1- 2013 127 692
- US-A1- 2014 152 642
- US-A1- 2014 347 253
- US-A1- 2014 347 332

## Description

### BACKGROUND OF THE INVENTION

### 1. Field of the Invention

The present invention relates to a current sensing circuit, and more particularly, to a current sensing circuit capable of compensating for degradation of an organic light emitting diode by stably sensing a current flowing on the organic light emitting diode, and an organic light emitting diode display having the same.

### 2. Background of the Invention

Recently, various types of flat panel displays (FPDs) for reducing a large weight and large volume, disadvantages of a cathode ray tube, are being developed. Such flat panel displays include a liquid crystal display (LCD), a field emission display (FED), a plasma display panel (PDP), an organic light emitting diode (OLED) display, etc.

Among the flat panel displays, the OLED display has advantages such as a rapid response speed, high light-emitting efficiency, high brightness and a large viewing angle, by using a spontaneous light emitting diode which emits light spontaneously.

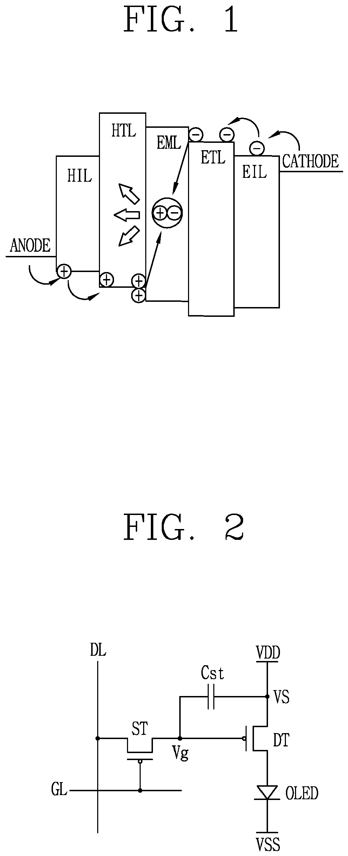

The OLED display is provided with an organic light emitting diode (OLED), a spontaneous light emitting device, as shown in FIG. 1. The organic light emitting diode includes an organic compound layer (HIL, HTL, EML, ETL, EIL) formed between an anode electrode and a cathode electrode.

The organic compound layer includes a hole injection layer (HIL), a hole transport layer (HTL), an emission layer (EML), an electron transport layer (ETL) and an electron injection layer (EIL). Once a driving voltage is applied to the anode electrode and the cathode electrode, holes passing through the hole transport layer (HTL) and electrons passing through the electron transport layer (ETL) move to the emission layer (EML) to form excitons. As a result, the emission layer (EML) generates visible rays.

The OLED arranges pixels each having the aforementioned organic light emitting diode in the form of matrices, and controls brightness of pixels selected by a gate signal based on a gray scale level of a data signal, thereby displaying an image.

FIG. 2 is an equivalent circuit of a single pixel of an organic light emitting diode display.

As shown in FIG. 2, each pixel of the organic light emitting diode display includes an organic light emitting diode (OLED), a gate line (GL) and a data line (DL) crossing each other, a switching TFT (ST), a driving TFT (DT) and a storage capacitor (Cst). Each of the switching TFT (ST) and the driving TFT (DT) are implemented as a P-type MOSFET.

The switching TFT (ST) is turned on in response to a gate signal provided from the gate line (GL), and conducts a current path between a source electrode and a drain electrode. The switching TFT (ST) applies a data signal provided through the data line (DL) to the driving TFT (DT) and the storage capacitor (Cst) during a turned-on period.

The driving TFT (DT) controls a current flowing on the OLED, based on a voltage difference (Vgs) between a gate electrode and a source electrode.

The storage capacitor (Cst) maintains a gate potential of the driving TFT (DT) constantly for a single frame.

The OLED is connected between a drain electrode and a basis voltage (VSS) of the driving TFT (DT), with a structure shown in FIG. 1.

In the OLED display having pixels, a brightness difference between the pixels may occur due to an electric characteristic difference of the driving TFT (DT), or a degradation difference of the OLED. Especially, the degradation difference of the OLED occurs due to a different degradation speed of each pixel when the OLED display is operated for a long time. If the degradation difference of the OLED becomes severe, image sticking occurs. This may cause a picture quality to be deteriorated.

US 2014/0152642 describes an error compensator and an organic light emitting display device using the same. The organic light emitting display device includes pixels each having a driving transistor and an organic light emitting diode, and a sensing unit extracting at least one of a first information including the threshold voltage of the driving transistor or a second information including the degradation of the organic light emitting diode from a pixel of the pixels. In the organic light emitting display device, the sensing unit includes an amplifier amplifying a voltage corresponding to the at least one of the first information or the second information; and an error compensator compensating for error components of elements included in the amplifier and the error compensator.

### SUMMARY OF THE INVENTION

Therefore, an aspect of the detailed description is to provide a current sensing circuit capable of compensating for degradation of an organic light emitting diode by sensing a current of the organic light emitting diode, and an organic light emitting diode display having the same.

To achieve these and other advantages and in accordance with the purpose of this specification, as embodied and broadly described herein, there is provided a current sensing circuit according to claim 1.

In one or more embodiments, the current buffer includes: an OPAMP (operational amplifier) comprising a first input terminal connected to the anode electrode of the organic light emitting diode, a second input terminal connected to the current integrator, and an output terminal; a first resistor connected between the first input terminal and the output terminal; and a second resistor connected between the second input terminal and the output terminal

In one or more embodiments, the current buffer is configured to control a level of the sensing current by controlling a ratio between sizes of the first and second resistors.

In one or more embodiments, the current buffer includes: a first switching device having a gate electrode and a drain electrode connected to the anode electrode of the organic light emitting diode; and a second switching device having a gate electrode connected to the gate electrode of the first switching device, and having a drain electrode connected to the current integrator, and wherein source electrodes of the first and second switching devices are commonly connected to a ground.

In one or more embodiments, the current buffer is configured to control a level of the sensing current by controlling a ratio between sizes of the first and second switching devices.

In one or more embodiments, the current sensing circuit further comprises a reference current source configured to provide a reference current by being connected to the current buffer.

In one or more embodiments, the current buffer is a current mirror circuit.

In one or more embodiments, the current integrator includes: a resistor connected to the current buffer; an OPAMP (operational amplifier) comprising a first input terminal to which a voltage by the sensing current is input through the resistor, a second input terminal to which a reference voltage is input, and an output terminal from which the sensing voltage is output; and a capacitor connected between the first input terminal and the output terminal.

In one or more embodiments, the current sensing circuit further comprises a switch disposed between the current buffer and the organic light emitting diode, wherein as the switch is turned on for a compensation driving period of the display panel, the sensing voltage is output through the current integrator.

Various embodiments further provide an organic light emitting diode display according to claim 10.

In one or more embodiments, the current sensing circuit is operated at a compensation driving period of the display panel.

To achieve these and other advantages and in accordance with the purpose of this specification, as embodied and broadly described herein, there is also provided an organic light emitting diode display, including: a display panel having a plurality of pixels, each pixel including an organic light emitting diode; a data driving unit having a current sensing circuit for outputting sensing data by sensing a pixel current from each of the plurality of pixels; and a timing controller configured to generate compensation image data by compensating for image data based on the sensing data, and to output the compensation image data to the data driving unit. The current sensing circuit may include: a plurality of sensing modules configured to sense the pixel currents by being connected to anode electrodes of the organic light emitting diodes disposed at the plurality of pixels, and to output a sensing voltage according to a sensing result; and an analogue-digital converter configured to convert the sensing voltage into an analogue-digital voltage, and to output the sensing data, wherein each of the plurality of sensing modules includes: a current buffer configured to generate a sensing current by sensing the pixel current from the anode electrode of the organic light emitting diode; and a current integrator configured to output the sensing voltage by receiving the sensing current as a voltage.

In one or more embodiments, the current sensing circuit is operated at a compensation driving period of the display panel.

Preferred embodiments are described in the dependent claims.

### [Effects]

The current sensing circuit of the present invention can enhance operation reliability of the current integrator, by providing the current buffer at a front end of the current integrator, the current buffer for generating a stable sensing current regardless of noise due to degradation or a switching operation of the organic light emitting diode.

Thus, the organic light emitting diode display of the present invention can enhance a picture quality by preventing image sticking by compensating for degradation of the organic light emitting diode.

Further scope of applicability of the present application will become more apparent from the detailed description given hereinafter. However, it should be understood that the detailed description and specific examples, while indicating preferred embodiments of the invention, are given by way of illustration only.

### BRIEF DESCRIPTION OF THE DRAWINGS

The accompanying drawings, which are included to provide a further understanding of the invention and are incorporated in and constitute a part of this specification, illustrate exemplary embodiments and together with the description serve to explain the principles of the invention.

In the drawings:
FIG. 1 is a view illustrating a light emitting principle of an organic light emitting diode display in accordance with the conventional art;
FIG. 2 is an equivalent circuit of a single pixel of an organic light emitting diode display;
FIG. 3 is a view illustrating a configuration of an organic light emitting diode display according to an embodiment of the present invention;
FIG. 4 is a view illustrating an equivalent circuit of a pixel shown in FIG. 3;
FIG. 5 is a view illustrating a detailed configuration of a timing controller and a data driving unit shown in FIG. 3;
FIG. 6 is a view illustrating an embodiment of one of a plurality of sensing modules shown in FIG. 5
FIG. 7 is a view illustrating another embodiment of one of the plurality of sensing modules shown in FIG. 5; and
FIGS. 8 and 9 are timing views by an operation of the conventional sensing circuit and a sensing circuit of the present invention.

### DETAILED DESCRIPTION OF THE INVENTION

Description will now be given in detail of preferred configurations of a current sensing circuit and an organic light emitting diode display including the same according to the present invention, with reference to the accompanying drawings.

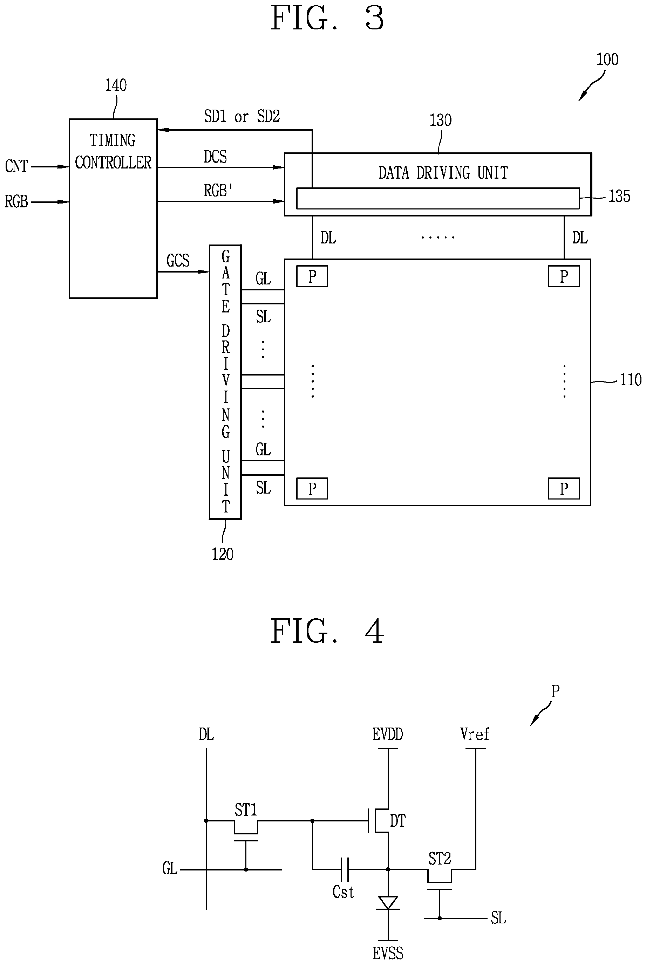

FIG. 3 is a view illustrating a configuration of an organic light emitting diode display according to an embodiment of the present invention, and FIG. 4 is a view illustrating an equivalent circuit of a pixel shown in FIG. 3.

Referring to FIG. 3, an organic light emitting diode display 100 according to an embodiment of the present invention may include a display panel 110, a gate driving unit 120, a data driving unit 130 and a timing controller 140.

A plurality of gate lines (GL) and a plurality of sensing lines (SL) may be formed to cross a plurality of data lines (DL) on the display panel 110, and pixels (P) may be formed at crossing regions in the form of matrices. The pixel (P) may be connected to a single gate line (GL), a single data line (DL) and a single sensing line (SL). A driving voltage (VDD) of a high potential and a reference voltage (Vref) of a high potential may be supplied to the pixel (P). The driving voltage (VDD) may be generated by a driving voltage source (not shown) as a predetermined level, and the reference voltage (Vref) may be generated by a reference voltage source (not shown) as a predetermined level.

Referring to FIG. 4, the pixel (P) may include an organic light emitting diode (OLED), a plurality of switching TFTs (ST1, ST2), a driving TFT (DT) and a storage capacitor (Cst). The plurality of switching TFTs (ST1, ST2) and the driving TFT (DT) may be implemented as an N-type MOSFET.

The OLED is connected between a drain electrode of the driving TFT (DT) and a basis voltage (VSS), and emits light by a current flowing between the driving voltage (VDD) and the basis voltage (VSS).

The first switching TFT (ST1) may output a data signal provided through the data line (DL) to a gate electrode of the driving TFT (DT), based on a gate signal provided through the gate line (GL).

The second switching TFT (ST2) may apply the reference voltage (Vref) to an anode electrode of the OLED, based on a sensing signal provided through the sensing line (SL).

The driving TFT(DT) is connected between the driving voltage (VDD) and the OLED, and may control the amount of current flowing to the OLED based on a voltage applied between the driving voltage (VDD) and the gate electrode.

The storage capacitor (Cst) is connected between a drain electrode of the first switching TFT (ST1) and the gate electrode of the driving TFT (DT). The storage capacitor (Cst) may maintain a voltage applied to the gate electrode of the driving TFT (DT), for a single frame.

Referring to FIG. 3, the gate driving unit 120 may generate a gate signal and a sensing signal based on a gate control signal (GCS) provided from the timing controller 140. The gate signal may be supplied to the plurality of gate lines (GL) of the display panel 110, and the sensing signal may be supplied to the plurality of sensing lines (SL) of the display panel 110. The gate driving unit 120 may be implemented as a shift register array, and may be formed on the display panel 110 as a gate in panel (GIP) type.

The data driving unit 130 may convert image data (e.g., compensation image data (RGB') output from the timing controller 140) into a data signal having an analogue voltage form, based on a data control signal (DCS) provided from the timing controller 140. And the data driving unit 130 may supply the data signal to the plurality of data lines (DL).

The data driving unit 130 may further include a sensing circuit 135 for sensing a current flowing on each pixel (P), generating sensing data (SD) according to a sensing result, and outputting the sensing data (SD).

The timing controller 140 may generate a gate control signal (GCS) and a data control signal (DCS) from a control signal (CNT) input from an external system (not shown), and may output the generated signals. The control signal (CNT) input from the external system may include a vertical synchronization signal (Vsync), a horizontal synchronization signal (Hsync), a dot clock signal (DCLK), a data enable signal (DE), etc. The gate control signal (GCS) may be output to the gate driving unit 120, and the data control signal (DCS) may be output to the data driving unit 130.

The timing controller 140 may generate image data by converting an image signal (RGB). The timing controller 140 may generate and output compensation image data (RGB') by compensating for the image data, based on sensing data (SD) output from the sensing circuit 135 of the data driving unit 130. The timing controller 140 may generate the compensation image data (RGB') by adding or deducting the sensing data (SD) to or from the image data. The compensation image data (RGB') may be output to the data driving unit 130 together with the data control signal (DCS).

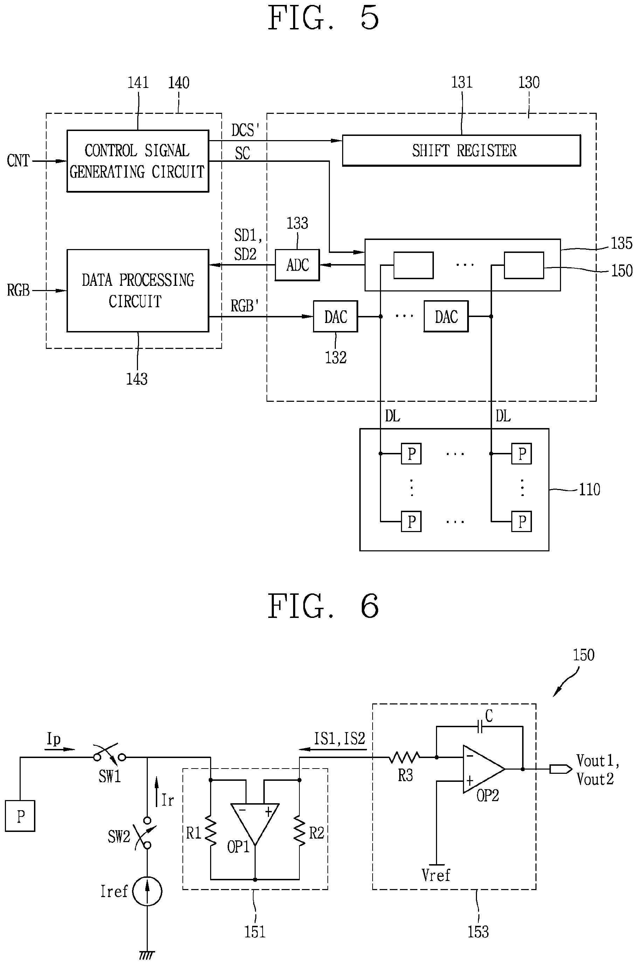

FIG. 5 is a view illustrating a detailed configuration of the timing controller and the data driving unit shown in FIG. 3.

Referring to FIGS. 3 and 5, the timing controller 140 may include a control signal generating circuit 141 and a data processing circuit 143.

The control signal generating circuit 141 may generate and output the data control signal (DCS) for controlling an operation timing of the data driving unit 130, based on the control signal (CNT) input from the external system.

The control signal generating circuit 141 may generate and output a switching control signal (SC) for controlling an operation of the sensing circuit 135 of the data driving unit 130 to be explained later.

The data processing circuit 143 may extract a characteristic value (e.g., current-voltage) of the OLED based on the sensing data (SD) input from the data driving unit 130, and may determine a compensation value according to an extraction result. The data processing circuit 143 may compensate for a gray scale level of image data generated from the image signal (RGB) based on the compensation value, thereby generating and outputting the compensation image data (RGB'). Such a compensation image data (RGB') may be used to solve nonuniform brightness between the pixels (P) due to degradation of the OLED.

The data driving unit 130 may include the sensing circuit 135, a shift register 131, an analogue-digital converter (ADC) 133, and a digital-analogue converter (DAC) 132.

The sensing circuit 135 may include a plurality of sensing modules 150. The plurality of sensing modules 150 may be connected to the plurality of data lines (DL) of the display panel 110, in a one-to-one manner. The sensing modules 150 may be operated for a compensation operation period of the organic light emitting diode display 100, based on the switching control signal (SC) output from the timing controller 140, thereby sensing a pixel current of each pixel (P) of the display panel 110. The sensing modules 150 may output a sensing voltage according to a sensing result.

The ADC 133 may be commonly connected to the plurality of sensing modules 150. The ADC 133 may sample a sensing voltage output from the plurality of sensing modules 150, and may output the sampled sensing voltage after converting it into sensing data (SD) of a digital signal. The sensing data (SD) may be output to the timing controller 140. The ADC 133 may be provided in plurality so as to be connected to the plurality of sensing modules 150 in a one-to-one manner.

The shift register 131 may sequentially shift sampling signals with respect to the compensation image data (RGB') based on the data control signal (DCS) output from the timing controller 140.

The DAC 132 may be provided in plurality so as to be connected to the plurality of data lines (DL) in a one-to-one manner. The DAC 132 may convert the compensation image data (RGB') output from the timing controller 140 into a data signal, based on a sampling signal output from the shift register 131. The data signal is output to the data lines (DL) of the display panel 110.

FIG. 6 is a view illustrating an embodiment of one of a plurality of sensing modules shown in FIG. 5.

Referring to FIGS. 5 and 6, the sensing module 150 may include a current buffer 151 and a current integrator 153.

The current buffer 151 may be connected to the pixel (P) of the display panel 110, e.g., the anode electrode of the OLED, through a first switch (SW1). The current buffer 151 may sense a pixel current (Ip) flowing on the OLED by a switching operation of the first switch (SW1), thereby generating a sensing current, e.g., a first sensing current (Is1).

The current buffer 151 may be connected to a reference current source (Iref) through a second switch (SW2). The current buffer 151 may generate a second sensing current (Is2) from a reference current (Ir) provided from the reference current source (Iref), by a switching operation of the second switch (SW2).

The first switch (SW1) and the second switch (SW2) are operated by the switching control signal (SC) provided from the timing controller 140. In this case, the first switch (SW1) and the second switch (SW2) may have different turn-on periods. The first switch (SW1) and the second switch (SW2) may be turned on for a compensation driving period of the organic light emitting diode display 100.

The current buffer 151 may include a first OPAMP(OP1), a first resistor (R1) and a second resistor (R2).

The first OPAMP(OP1) may include a first input terminal (-), a second input terminal (+) and an output terminal. The first input terminal (-) of the first OPAMP(OP1) may be connected to each pixel (P) through the first switch (SW1), or may be connected to the reference current source (Iref) through the second switch (SW2). The first resistor (R1) may be connected between the first input terminal (-) and the output terminal of the first OPAMP(OP1). The second input terminal (+) of the first OPAMP(OP1) may be connected to the current integrator 153 to be explained later. The second resistor (R2) may be connected between the second input terminal (+) and the output terminal of the first OPAMP(OP1).

The aforementioned current buffer 151 may be operated as a current mirror circuit. For instance, if the pixel current (Ip) is input to the first input terminal (-) of the first OPAMP(OP1) as the first switch (SW1) is turned on, a first sensing current (Is1) may be generated from the second input terminal (+) of the first OPAMP(OP1) according to a ratio between sizes of the first resistor (R1) and the second resistor (R2)

If the first resistor (R1) and the second resistor (R2) have the same size, the pixel current (Ip) and the first sensing current (Is1) may also have the same level. However, the level of the pixel current (Ip) may be very small according to a degradation degree of the OLED. As a result, the level of the first sensing current (Is1) generated from the current buffer 151 may be also very small. For a stable operation of the current integrator 153 to which the first sensing current (Is1) is input, the first sensing current (Is1) should have a larger level than the pixel current (Ip), and the first resistor (R1) should have a larger size than the second resistor (R2).

If the reference current (Ir) is input to the first input terminal (-) of the first OPAMP(OP1) as the second switch (SW2) is turned on, a second sensing current (Is2) may be generated from the second input terminal (+) of the first OPAMP(OP1) according to a ratio between the sizes of the first resistor (R1) and the second resistor (R2).

Likewise, if the first resistor (R1) and the second resistor (R2) have the same size, the reference current (Ir) and the second sensing current (Is2) may also have the same level. However, if noise is generated by a switching operation of the second switch (SW2), a current having a peak component due to the noise may be generated from the reference current (Ir). Such a current having a peak component may cause a large current difference on the reference current (Ir), resulting in a malfunction of the current integrator 153. For a stable operation of the current integrator 153 to which the second sensing current (Is2) is input, the second sensing current (Is2) should have a smaller level than the reference current (Ir), and the first resistor (R1) should have a smaller size than the second resistor (R2).

The current integrator 153, connected to the current buffer 151, may output a first sensing voltage (Vout1) and a second sensing voltage (Vout2) according to a sensing current generated from the current buffer 151, i.e., the first sensing current (Is1) and the second sensing current (Is2). The current integrator 153 may include a second OPAMP(OP2), a third resistor (R3) and a feedback capacitor (C).

The second OPAMP(OP2) may include a first input terminal (-), a second input terminal (+) and an output terminal. The first input terminal (-) of the second OPAMP(OP2) may be connected to the current buffer 151 through the third resistor (R3). A current generated from the current buffer 151 may be input to the first input terminal (-) of the second OPAMP(OP2), in the form of a voltage. For instance, the first sensing current (Is1) may be input to the first input terminal (-) as a first voltage, by the third resistor (R3). And the second sensing current (Is2) may be input to the first input terminal (-) as a second voltage, by the third resistor (R3). A reference voltage (Vref) may be input to the second input terminal (+) of the second OPAMP(OP2). And the feedback capacitor (C) may be connected between the output terminal and the first input terminal (-) of the second OPAMP(OP2).

The aforementioned current integrator 153 may output the first sensing voltage (Vout1) based on the first sensing current (Is1) generated from the current buffer 151, and may output the second sensing voltage (Vout2) based on the second sensing current (Is2) generated from the current buffer 151.

The ADC 133 of the data driving unit 130 may generate and output first compensation data (SD1) based on the first sensing voltage (Vout1), and may generate and output second compensation data (SD2) based on the second sensing voltage (Vout2). The first compensation data (SD1) may be data for compensating for a gray scale level of a data signal according to a degradation degree of the OLED, and the second compensation data (SD2) may be data for compensating for a gray scale level of a data signal according to a size of the feedback capacitor (C) of the current integrator 153.

The timing controller 140 may generate compensation image data (RGB') based on the first sensing data (SD1) and the second sensing data (SD2). The compensation image data (RGB') may be output to the data lines (DL) of the display panel 110 through the DAC 132 of the data driving unit 130.

As aforementioned, the sensing module 150 according to one embodiment includes the current integrator 153, and the current buffer 151 disposed at a front end of the current integrator 153, and operated as a current mirror circuit by being composed of an OPAMP and a resistor. With such a configuration, the current integrator 153 is stably operated by a sensing current generated from the current buffer 151. This may enhance reliability in operation. Further, the current integrator 153 may have a stable operation by controlling a ratio between resistors inside the current buffer 151, and then by controlling a level of the sensing current.

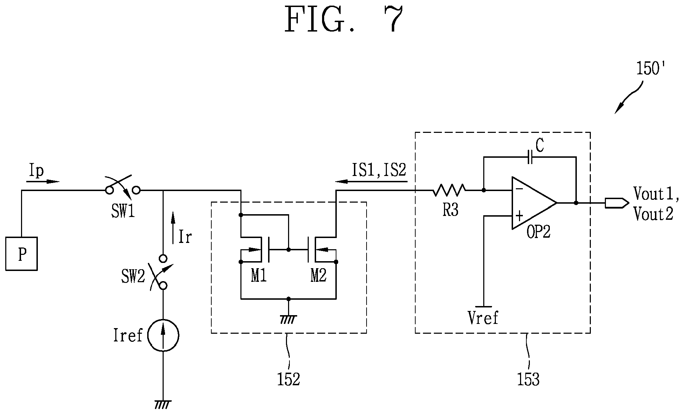

FIG. 7 is a view illustrating another embodiment of one of the plurality of sensing modules shown in FIG. 5.

A sensing module 150' according to another embodiment has the same configuration as the sensing module 150 shown in FIG. 6, except for the current buffer 152. Thus, the same components will have the same reference numerals, and detailed explanations thereof will be omitted.

Referring to FIGS. 5 and 7, the sensing module 150' may include a current buffer 152 and a current integrator 153.

The current buffer 152 may sense a pixel current (Ip) from each pixel (P) of the display panel 110 through a first switch (SW1), thereby generating a first sensing current (Is1). And the current buffer 152 may generate a second sensing current (Is2), by receiving a reference current (Ir) from a reference current source (Iref), through a second switch (SW2).

The current buffer 152 may include a first switching device (M1) and a second switching device (M2). The first switching device (M1) and the second switching device (M2) may be implemented as an N-type MOSFET.

A gate electrode and a drain electrode of the first switching device (M1) may be connected to the pixel (P) through the first switch (SW1), or may be connected to the reference current source (Iref) through the second switch (SW2). A gate electrode of the second switching device (M2) may be connected to the gate electrode of the first switching device (M1), and a drain electrode of the second switching device (M2) may be connected to a first input terminal (-) of the current integrator 153. Source electrodes of the first switching device (M1) and the second switching device (M2) may be commonly connected to a ground (GND).

The aforementioned current buffer 152 may be operated as a current mirror circuit. A level of the pixel current (Ip) and the first sensing current (Is1) or the reference current (Ir) and the second sensing current (Is2) may be variable according to a ratio between sizes (areas) of the first switching device (M1) and the second switching device (M2).

As aforementioned, since the first sensing current (Is1) should have a larger level than the pixel current (Ip), the first switching device (M1) is preferably formed to have a smaller size than the second switching device (M2). Further, since the second sensing current (Is2) should have a smaller level than the reference current (Ir), the first switching device (M1) is preferably formed to have a larger size than the second switching device (M2).

The current integrator 153, connected to the current buffer 151, may output a first sensing voltage (Vout1) and a second sensing voltage (Vout2) based on a sensing current generated from the current buffer 151, i.e., the first sensing current (Is1) and the second sensing current (Is2). The current integrator 153 may include a second OPAMP(OP2), a third resistor (R3) and a feedback capacitor (C).

The ADC 133 of the data driving unit 130 may generate and output first compensation data (SD1) based on the first sensing voltage (Vout1), and may generate and output second compensation data (SD2) based on the second sensing voltage (Vout2).

The timing controller 140 may generate compensation image data (RGB') based on the first sensing data (SD1) and the second sensing data (SD2). The compensation image data (RGB') may be output to the data lines (DL) of the display panel 110 through the DAC 132 of the data driving unit 130.

As aforementioned, the sensing module 150' according to another embodiment includes the current integrator 153, and the current buffer 151 disposed at a front end of the current integrator 153, and operated as a current mirror circuit by being composed of switching devices. With such a configuration, the current integrator 153 is stably operated by a sensing current generated from the current buffer 151. This may enhance reliability in operation. Further, the current integrator 153 may have a stable operation by controlling a ratio between areas of the switching devices inside the current buffer 151, and then by controlling a level of the sensing current.

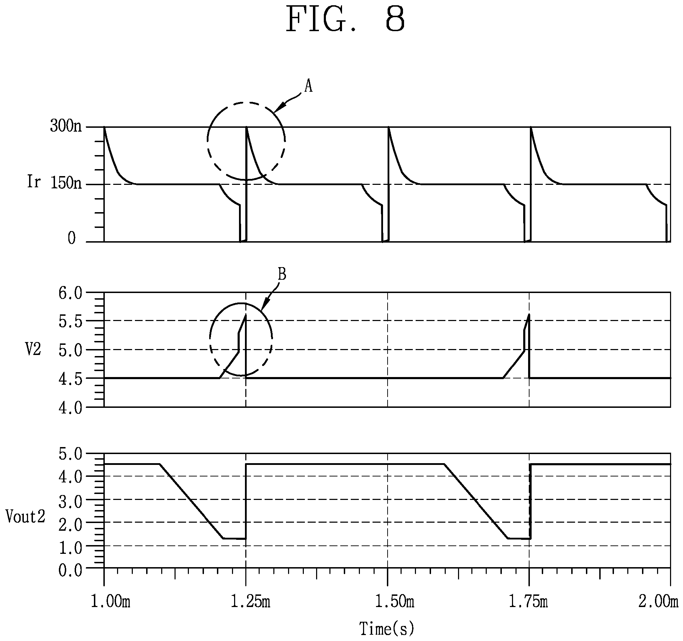

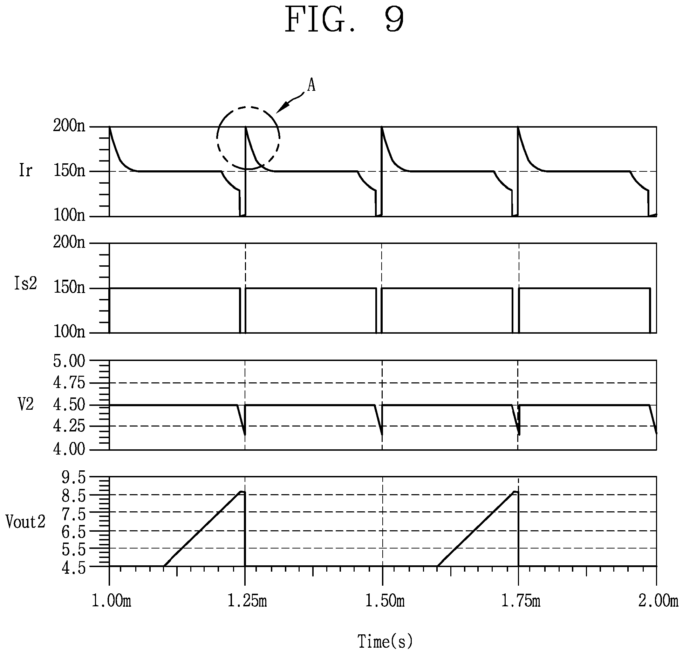

FIGS. 8 and 9 are timing views by an operation of the conventional sensing circuit and a sensing circuit of the present invention.

As shown in FIGS. 8 and 9, the reference current (Ir) output from the reference current source (Iref) has noise (A) due to a switching operation of the second switch (SW2). Such noise (A) should be removed because it may cause a malfunction of the current integrator.

As shown in FIG. 8, since the noise (A) occurred from the reference current (Ir) on the conventional sensing circuit is not removed, a peak component (B) occurs from a voltage input to the current integrator, e.g., a second voltage (V2). The current integrator may have an unstable operation due to the voltage having the peak component (B), and this may reduce a level of the output voltage (Vout2). As a result, performance of the sensing circuit is lowered, and it is impossible to compensate for degradation of the organic light emitting diode display.

On the other hand, as shown in FIG. 9, in the sensing circuit 135 of the present invention, the second sensing current (Is2) having noise removed therefrom may be output from the reference current (Ir), by the current buffer 151 of the sensing module 150. As a result, the second voltage input to the current integrator 153 does not have a peak component.

The current integrator 153 may output the second sensing voltage (Vout2) based on the reference voltage (Vref) and the second voltage (V2). The second sensing voltage (Vout2) may be output to increase up to a predetermined level.

That is, in the sensing circuit 135 of the present invention, noise (A) of the reference current (Ir) is removed from the current buffer 151. Accordingly, the second voltage (V2) input to the current integrator 153 may have a predetermined level, and thus the current integrator 153 may be stably operated.

As aforementioned, even if the reference current (Ir) having a large peak component is input from the reference current source (Iref), the second sensing current (Is2) of a small level may be generated by controlling a resistor size of the current buffer 151. This may allow the current integrator 153 to be stably operated.

As the present features may be embodied in several forms without departing from the characteristics thereof, it should also be understood that the above-described embodiments are not limited by any of the details of the foregoing description, unless otherwise specified, but rather should be construed broadly within its scope as defined in the appended claims.

## Claims

1. A current sensing circuit (135) for an organic light emitting diode display, the display comprising:
a display panel having an organic light emitting diode (OLED) in each of a plurality of pixels (P), each pixel being configured to receive image data signals provided through a data line (DL);
a timing controller (140) configured to generate compensation image data (RGB') by converting an image signal (RGB) input thereto,
a data drive unit (130) configured to apply image data signals to each of a plurality of said data lines; and
said current sensing circuit (135) comprising:
a plurality of sensing modules (150) configured to sense a pixel current (Ip) from pixels of said display panel (110),
and to output a sensing voltage (Vout1) according to a sensing result of the pixel current (Ip), each said sensing module comprising:
a current buffer (151, 152) configured to generate a sensing current (IS1) in response to receiving the pixel current (Ip), from an anode electrode of the organic light emitting diode (OLED) of a said pixel (P), at an input terminal thereof; and a current integrator (153) configured to output the sensing voltage (Vout1), the sensing voltage (Vout1) being output in response to receiving the sensing current (IS1); and
an analogue-digital converter (133) configured to convert the sensing voltage (Vout1) into digital sensing data (SD1);
and
wherein the timing controller (140) is configured to generate the compensation image data (RGB')
by compensating the image signal input (RGB) based on the digital sensing data, and to output the compensation image data to said data drive unit (130),
**characterised in that** each said sensing module (150) further includes:
a first switch (SW1) through which the input terminal of the current buffer (151, 152) may be connected to the anode of the organic light emitting diode (OLED) of a pixel (P) to thereby generate a first sensing current (IS1) in response to a said pixel current (Ip); and
a second switch (SW2) through which the input terminal of the current buffer (151, 152) may be connected to a reference current source (Iref) to thereby generate a second sensing current (IS2) in response to a reference current (Ir);
wherein the current integrator (153) is configured to output a first sensing voltage (Vout1) in response to receiving the first sensing current (IS1), and to output a second sensing voltage (Vout2) in response to receiving the second sensing current (IS2); wherein the analogue-digital converter (133) is configured to convert the output first and second voltages (Vout1, Vout2) into first and second digital sensing data (SD1, SD2); and
wherein the timing controller (140) is configured to generate the compensation image data (RGB') based on the first and the second digital sensing data (SD1, SD2).

2. The current sensing circuit (135) of claim 1, wherein the current buffer (151) includes:
an OPAMP (OP1) comprising a first input terminal connected to the first and second switches (SW1, SW2), a second input terminal connected to the current integrator (153), and an output terminal;
a first resistor (R1) connected between the first input terminal and the output terminal; and
a second resistor (R2) connected between the second input terminal and the output terminal.

3. The current sensing circuit (135) of claim 2, wherein the current buffer (151) is configured to control levels of the first and second sensing currents (IS1, IS2) with respect to the pixel current (Ip) and the reference current (Ir) by controlling a ratio between sizes of the first and second resistors (R1, R2).

4. The current sensing circuit (135) of claim 1, wherein the current buffer (152) includes:
a first switching device (M1) having a gate electrode and a drain electrode connected to the first and second switches (SW1, SW2); and
a second switching device (M2) having a gate electrode connected to the gate electrode of the first switching device (M1), and having a drain electrode connected to the current integrator (153), and
wherein source electrodes of the first and second switching devices (M1, M2) are commonly connected to a ground.

5. The current sensing circuit (135) of claim 4, wherein the current buffer (152) is configured to control levels of the first and second sensing currents (IS1, IS2) with reference to the pixel current (Ip) and the reference current (Ir) by controlling a ratio between sizes of the first and second switching devices (M1, M2).

6. The current sensing circuit (135) of claim 1, 4 or 5, wherein the current buffer (152) is a current mirror circuit.

7. The current sensing circuit (135) of any one of claims 1 to 6, wherein the current integrator (153) includes:
a resistor (R3) connected to the current buffer (151, 152);
an OPAMP (OP2) comprising a first input terminal to which voltages by the first and second sensing currents (IS1, IS2) are input through the resistor (R3), a second input terminal to which a reference voltage (Vref) is input, and an output terminal from which the first and second sensing voltages (Vout1, Vout2) are output; and
a capacitor (C) connected between the first input terminal and the output terminal.

8. The current sensing circuit (135) of any one of claims 1 to 7, wherein as the first switch (SW1) and the second switch (SW2) are turned on for a compensation driving period of the display panel (110), the first and second sensing voltages (Vout1, Vout2) are output through the current integrator (153).

9. An organic light emitting diode display, comprising:
a display panel (110) having a plurality of pixels (P), each pixel (P) including an organic light emitting diode (OLED), each pixel being configured to receive image data signal provided through a data line (DL);
a data driving unit (130) configured to apply image data signals to each of a plurality of said data lines and having a current sensing circuit (135) according to any one of claims 1 to 8, said current sensing circuit being configured to output sensing data in response to sensing a pixel current (Ip) from each of the plurality of pixels (P) and a reference current (Ir) from a reference current source (Iref); and
a timing controller (140) configured to generate compensation image data by compensating image data based on the sensing data, and to output the compensation image data to the data driving unit (130),
wherein the first switches (SW1) of each of the plurality of sensing modules (150) of the current sensing (135) circuit are configured to be connected to anode electrodes of the organic light emitting diodes (OLED).

10. The organic light emitting diode display of claim 9, wherein the current sensing circuit (135) is operated at a compensation driving period of the display panel (110).

## Patentansprüche

1. Eine Strom-Abtastschaltung (135) für eine Organische-Lichtemittierende-Diode-Anzeige, wobei die Anzeige aufweist:
ein Anzeigepanel, das eine organische lichtemittierende Diode (OLED) in jedem von einer Mehrzahl von Pixeln (P) aufweist, wobei jedes Pixel konfiguriert ist zum Empfangen von Bilddatensignalen, die über eine Datenleitung (DL) bereitgestellt werden;
eine Timing-Steuereinheit (140), die konfiguriert ist zum Erzeugen von Kompensationsbilddaten (RGB') durch Konvertieren eines dorthinein eingegebenen Bildsignals (RGB),
eine Datentreibereinheit (130), die konfiguriert ist, um Bilddatensignale an jede von einer Mehrzahl der Datenleitungen bereitzustellen; und
wobei die Strom-Abtastschaltung (135) aufweist:
eine Mehrzahl von Abtastmodulen (150), die konfiguriert sind, um einen Pixelstrom (Ip) von Pixeln des Anzeigepanels (110) zu erfassen und um eine Abtastspannung (Vout1) gemäß einem Abtastergebnis des Pixelstroms (Ip) auszugeben, wobei jedes Abtastmodul aufweist:
einen Strompuffer (151, 152), der konfiguriert ist zum Erzeugen eines Abtaststroms (IS1) als Antwort auf das Empfangen des Pixelstroms (Ip) von einer Anodenelektrode der organischen lichtemittierenden Diode (OLED) des Pixels (P) an einem Eingangsanschluss davon; und
einen Stromintegrator (153), der konfiguriert ist zum Ausgeben der Abtastspannung (Vout1), wobei die Abtastspannung (Vout1) als Antwort auf das Empfangen des Abtaststroms (IS1) ausgegeben wird; und
einen Analog-Digital-Wandler (133), der konfiguriert ist, um die Abtastspannung (Vout1) in digitale Abtastdaten (SD1) zu konvertieren;
wobei die Timing-Steuereinheit (140) konfiguriert ist, um die Kompensationsbilddaten (RGB') durch Kompensieren des Bildsignaleingangs (RGB) basierend auf den digitalen Abtastdaten zu erzeugen und um die Kompensationsbilddaten an die Datentreibereinheit (130) auszugeben,
**dadurch gekennzeichnet, dass** jedes Abtastmodul (150) ferner aufweist:
einen ersten Schalter (SW1), durch den der Eingangsanschluss des Strompuffers (151, 152) mit der Anode der organischen lichtemittierenden Diode (OLED) eines Pixels (P) verbunden werden kann, um dadurch einen ersten Abtaststrom (IS1) als Antwort auf einen Pixelstrom (Ip) zu erzeugen; und
einen zweiten Schalter (SW2), durch welchen der Eingangsanschluss des Strompuffers (151, 152) mit einer Referenzstromquelle (Iref) verbunden werden kann, um dadurch einen zweiten Abtaststrom (IS2) als Antwort auf einen Referenzstrom (Ir) zu erzeugen;
wobei der Stromintegrator (153) konfiguriert ist, um eine erste Abtastspannung (Vout1) als Antwort auf das Empfangen des ersten Abtaststroms (IS1) auszugeben und um eine zweite Abtastspannung (Vout2) als Antwort auf das Empfangen des zweiten Abtaststroms (IS2) auszugeben;
wobei der Analog-Digital-Wandler (133) konfiguriert ist, um die ausgegebene erste und zweite Abtastspannung (Vout1, Vout2) in erste und zweite digitale Abtastdaten (SD1, SD2) zu konvertieren; und
wobei die Timing-Steuereinheit (140) konfiguriert ist zum Erzeugen der Kompensationsbilddaten (RGB') basierend auf den ersten und den zweiten digitalen Abtastdaten (SD1, SD2).

2. Die Strom-Abtastschaltung (135) gemäß Anspruch 1, wobei der Strompuffer (151) aufweist:
einen OPAMP (OP1), der einen ersten Eingangsanschluss, welcher mit dem ersten und dem zweiten Schalter (SW1, SW2) verbunden ist, einen zweiten Eingangsanschluss, welcher mit dem Stromintegrator (153) verbunden ist, und einen Ausgangsanschluss aufweist;
einen ersten Widerstand (R1), der zwischen den ersten Eingangsanschluss und den Ausgangsanschluss geschaltet ist; und
einen zweiten Widerstand (R2), der zwischen den zweiten Eingangsanschluss und den Ausgangsanschluss geschaltet ist.

3. Die Strom-Abtastschaltung (135) gemäß Anspruch 2, wobei der Strompuffer (151) konfiguriert ist zum Steuern von Pegeln des ersten und des zweiten Abtaststroms (IS1, IS2) in Bezug auf den Pixelstrom (Ip) und den Referenzstrom (Ir) durch Steuern eines Verhältnisses zwischen Größen des ersten und des zweiten Widerstands (R1, R2).

4. Die Strom-Abtastschaltung (135) gemäß Anspruch 1, wobei der Strompuffer (152) aufweist:
eine erste Schaltvorrichtung (M1), die eine Gate-Elektrode und eine Drain-Elektrode aufweist, welche mit dem ersten Schalter und dem zweiten Schalter (SW1, SW2) verbunden sind; und
eine zweite Schaltvorrichtung (M2), die eine Gate-Elektrode, welche mit der Gate-Elektrode der ersten Schaltvorrichtung (M1) verbunden ist, und eine Drain-Elektrode, welche mit dem Stromintegrator (153) verbunden ist, aufweist,
wobei Source-Elektroden der ersten und der zweiten Schaltvorrichtung (M1, M2) gemeinsam mit einer Masse verbunden sind.

5. Die Strom-Abtastschaltung (135) gemäß Anspruch 4, wobei der Strompuffer (152) konfiguriert ist zum Steuern von Pegeln des ersten und des zweiten Abtaststroms (IS1, IS2) in Bezug auf den Pixelstrom (Ip) und den Referenzstrom (Ir) durch Steuern eines Verhältnisses zwischen Größen der ersten und der zweiten Schaltvorrichtung (M1, M2).

6. Die Strom-Abtastschaltung (135) gemäß Anspruch 1, 4 oder 5, wobei der Strompuffer (152) eine Stromspiegelschaltung ist.

7. Die Strom-Abtastschaltung (135) gemäß irgendeinem der Ansprüche 1 bis 6, wobei der Stromintegrator (153) aufweist:
einen Widerstand (R3), der mit dem Strompuffer (151, 152) verbunden ist;
einen OPAMP (OP2), welcher einen ersten Eingangsanschluss, an den Spannungen durch den ersten und den zweiten Abtaststrom (IS1, IS2) durch den Widerstand (R3) eingegeben werden, einen zweiten Eingangsanschluss, an den eine Referenzspannung (Vref) eingegeben wird, und einen Ausgangsanschluss aufweist, von welchem die erste und die zweite Abtastspannung (Vout1, Vout2) ausgegeben werden; und
einen Kondensator (C), der zwischen den ersten Eingangsanschluss und den Ausgangsanschluss geschaltet ist.

8. Die Strom-Abtastschaltung (135) gemäß irgendeinem der Ansprüche 1 bis 7, wobei, wenn der erste Schalter (SW1) und der zweite Schalter (SW2) für eine Kompensation-Ansteuerperiode des Displaypanels (110) angeschaltet werden, die erste und die zweite Abtastspannung (Vout1, Vout2) durch den Stromintegrator (153) ausgegeben werden.

9. Eine Organische-Lichtemittierende-Diode-Anzeige, aufweisend:
ein Anzeigepanel (110), das eine Mehrzahl von Pixeln (P) aufweist, wobei jedes Pixel (P) eine organische lichtemittierende Diode (OLED) aufweist, wobei jedes Pixel konfiguriert ist zum Empfangen eines Bilddatensignals, das über eine Datenleitung (DL) bereitgestellt wird;
eine Datentreibereinheit (130), die konfiguriert ist, um Bilddatensignale an jede von einer Mehrzahl der Datenleitungen bereitzustellen, und die eine Strom-Abtastschaltung (135) gemäß irgendeinem der Ansprüche 1 bis 8 aufweist, wobei die Strom-Abtastschaltung konfiguriert ist zum Ausgeben von Abtastdaten als Antwort auf das Erfassen eines Pixelstroms (Ip) von jedem der Mehrzahl von Pixeln (P) und eines Referenzstroms (Ir) von einer Referenzstromquelle (Iref); und
eine Timing-Steuereinheit (140), die konfiguriert ist zum Erzeugen von Kompensationsbilddaten durch Kompensieren von Bilddaten basierend auf den Abtastdaten, und zum Ausgeben der Kompensationsbilddaten an die Datentreibereinheit (130),
wobei die ersten Schalter (SW1) von jedem der Mehrzahl von Abtastmodulen (150) der Strom-Abtastschaltung (135) konfiguriert sind, um mit Anodenelektroden der organischen lichtemittierenden Dioden (OLED) verbunden zu werden.

10. Die Organische-Lichtemittierende-Dioden-Anzeige gemäß Anspruch 9, wobei die Strom-Abtastschaltung (135) während einer Kompensation-Ansteuerperiode des Anzeigepanels (110) betrieben wird.

## Revendications

1. Circuit de détection de courant (135) pour un afficheur à diode électroluminescente organique, l'affichage comprenant :
un panneau d'affichage présentant une diode électroluminescente organique (OLED) dans chaque pixel d'une pluralité de pixels (P), chaque pixel étant configuré de manière à recevoir des signaux de données d'image fournis à travers une ligne de données (DL) ;
un contrôleur de temporisation (140) configuré de manière à générer des données d'image de compensation (RGB') en convertissant un signal d'image (RGB) entré dans celui-ci ;
une unité de commande de données (130) configurée de manière à appliquer des signaux de données d'image à chacune d'une pluralité desdites lignes de données ; et
ledit circuit de détection de courant (135) comprenant :
une pluralité de modules de détection (150) configurés de manière à détecter un courant de pixel (Ip) à partir de pixels dudit panneau d'affichage (110), et à fournir en sortie une tension de détection (Vout1) selon un résultat de détection du courant de pixel (Ip), chaque dit module de détection comprenant :
un tampon de courant (151, 152) configuré de manière à générer un courant de détection (IS1) en réponse à la réception du courant de pixel (Ip), à partir d'une électrode anodique de la diode électroluminescente organique (OLED) dudit pixel (P), au niveau d'une borne d'entrée connexe ; et
un intégrateur de courant (153) configuré de manière à fournir en sortie la tension de détection (Vout1), la tension de détection (Vout1) étant fournie en sortie en réponse à la réception du courant de détection (IS1) ; et
un convertisseur analogique-numérique (133) configuré de manière à convertir la tension de détection (Vout1) en des données de détection numériques (SD1) ; et
dans lequel le contrôleur de temporisation (140) est configuré de manière à générer les données d'image de compensation (RGB') en compensant l'entrée de signal d'image (RGB) sur la base des données de détection numériques, et à fournir en sortie les données d'image de compensation à ladite unité de commande de données (130), **caractérisé en ce que** chaque dit module de détection (150) inclut en outre :
un premier commutateur (SW1) à travers lequel la borne d'entrée du tampon de courant (151, 152) peut être connectée à l'anode de la diode électroluminescente organique (OLED) d'un pixel (P), en vue de générer par conséquent un premier courant de détection (IS1) en réponse audit courant de pixel (Ip) ; et
un second commutateur (SW2) à travers lequel la borne d'entrée du tampon de courant (151, 152) peut être connectée à une source de courant de référence (Iref), en vue de générer par conséquent un second courant de détection (IS2) en réponse à un courant de référence (Ir) ;
dans lequel l'intégrateur de courant (153) est configuré de manière à fournir en sortie une première tension de détection (Vout1) en réponse à la réception du premier courant de détection (IS1), et à fournir en sortie une seconde tension de détection (Vout2) en réponse à la réception du second courant de détection (IS2) ;
dans lequel le convertisseur analogique-numérique (133) est configuré de manière à convertir les première et seconde tensions sorties (Vout1, Vout2) en des premières et secondes données de détection numériques (SD1, SD2) ; et
dans lequel le contrôleur de temporisation (140) est configuré de manière à générer les données d'image de compensation (RGB') sur la base des premières et secondes données de détection numériques (SD1, SD2).

2. Circuit de détection de courant (135) selon la revendication 1, dans lequel le tampon de courant (151) comprend :
un amplificateur opérationnel, OPAMP, (OP1) comprenant une première borne d'entrée connectée aux premier et second commutateurs (SW1, SW2) ;
une seconde borne d'entrée connectée à l'intégrateur de courant (153), et une borne de sortie ;
une première résistance (R1) connectée entre la première borne d'entrée et la borne de sortie ; et
une seconde résistance (R2) connectée entre la seconde borne d'entrée et la borne de sortie.

3. Circuit de détection de courant (135) selon la revendication 2, dans lequel le tampon de courant (151) est configuré de manière à commander des niveaux des premier et second courants de détection (IS1, IS2) par rapport au courant de pixel (Ip) et au courant de référence (Ir), en commandant un rapport entre des tailles des première et seconde résistances (R1, R2).

4. Circuit de détection de courant (135) selon la revendication 1, dans lequel le tampon de courant (152) inclut :
un premier dispositif de commutation (M1) présentant une électrode grille et une électrode déversoir connectées aux premier et second commutateurs (SW1, SW2) ; et
un second dispositif de commutation (M2) présentant une électrode grille connectée à l'électrode grille du premier dispositif de commutation (M1), et présentant une électrode déversoir connectée à l'intégrateur de courant (153) ; et
dans lequel des électrodes sources des premier et second dispositifs de commutation (M1, M2) sont communément connectées à une masse.

5. Circuit de détection de courant (135) selon la revendication 4, dans lequel le tampon de courant (152) est configuré de manière à commander des niveaux des premier et second courants de détection (IS1, IS2) en référence au courant de pixel (Ip) et au courant de référence (Ir), en commandant un rapport entre des tailles des premier et second dispositifs de commutation (M1, M2).

6. Circuit de détection de courant (135) selon la revendication 1, 4 ou 5, dans lequel le tampon de courant (152) est un circuit miroir de courant.

7. Circuit de détection de courant (135) selon l'une quelconque des revendications 1 à 6, dans lequel l'intégrateur de courant (153) inclut :
une résistance (R3) connectée au tampon de courant (151, 152) ;
un amplificateur opérationnel, OPAMP, (OP2) comprenant une première borne d'entrée dans laquelle des tensions à travers les premier et second courants de détection (IS1, IS2) sont appliquées en entrée à travers la résistance (R3), une seconde borne d'entrée dans laquelle une tension de référence (Vref) est appliquée en entrée, et une borne de sortie à partir de laquelle les première et seconde tensions de détection (Vout1, Vout2) sont fournies en sortie ; et
un condensateur (C) connecté entre la première borne d'entrée et la borne de sortie.

8. Circuit de détection de courant (135) selon l'une quelconque des revendications 1 à 7, dans lequel, lorsque le premier commutateur (SW1) et le second commutateur (SW2) sont mis sous tension pendant une période de commande de compensation du panneau d'affichage (110), les première et seconde tensions de détection (Vout1, Vout2) sont fournies en sortie à travers l'intégrateur de courant (153).

9. Afficheur à diode électroluminescente organique, comprenant :
un panneau d'affichage (110) présentant une pluralité de pixels (P), chaque pixel (P) incluant une diode électroluminescente organique (OLED), chaque pixel étant configuré de manière à recevoir un signal de données d'image fourni à travers une ligne de données (DL) ;
une unité de commande de données (130) configurée de manière à appliquer des signaux de données d'image à chaque ligne d'une pluralité desdites lignes de données, et présentant un circuit de détection de courant (135) selon l'une quelconque des revendications 1 à 8, ledit circuit de détection de courant étant configuré de manière à fournir en sortie des données de détection en réponse à la détection d'un courant de pixel (Ip) provenant de chaque pixel de la pluralité de pixels (P) et d'un courant de référence (Ir) provenant d'une source de courant de référence (Iref) ; et
un contrôleur de temporisation (140) configuré de manière à générer des données d'image de compensation en compensant des données d'image sur la base des données de détection, et à fournir en sortie les données d'image de compensation à l'unité de commande de données (130) ;
dans lequel les premiers commutateurs (SW1) de chaque module de la pluralité de modules de détection (150) du circuit de détection de courant (135) sont configurés de manière à être connectés à des électrodes anodiques des diodes électroluminescentes organiques (OLED).

10. Afficheur à diode électroluminescente organique selon la revendication 9, dans lequel le circuit de détection de courant (135) est exploité au cours d'une période de commande de compensation du panneau d'affichage (110).
